# FASCICULE DE BREVET EUROPEEN

(11) **EP 4 004 964 B1**
(45) Date de publication et mention de la délivrance du brevet: **16.08.2023**
(21) Numéro de dépôt: 20742747.7
(22) Date de dépôt: 23.07.2020
(51) Int. Cl.: H01J 37/285, H01J 37/20

(54) **SONDE ATOMIQUE TOMOGRAPHIQUE À GÉNÉRATEUR D'IMPULSIONS TÉRAHERTZ**
TOMOGRAFISCHE ATOMSONDE MIT TERAHERTZ-PULSGENERATOR
TOMOGRAPHIC ATOM PROBE WITH TERAHERTZ PULSE GENERATOR

(30) Priorité: 29.07.2019 FR 1908599
(43) Date de publication de la demande: 01.06.2022
(73) Titulaire: Centre national de la recherche scientifique, 75016 Paris (FR); Institut National Des Sciences Appliquées De Rouen, 76800 Saint-Etienne-du-Rouvray (FR); Universite de Rouen Normandie, 76130 Mont-Saint-Aignan (FR)
(72) Inventeur: VELLA, Angela, 76000 ROUEN (FR); HOUARD, Jonathan, 76100 ROUEN (FR); HIDEUR, Ammar, 76140 Le Petit-Quevilly (FR); ARNOLDI, Laurent, 76100 ROUEN (FR); RIGUTTI, Lorenzo, 76230 BOIS GUILLAUME (FR)
(74) Mandataire: Atout PI Laplace
(86) Numéro de dépôt international: PCT/EP2020/070775
(87) Numéro de publication internationale: WO 2021/018719

(56) Documents cités:
- VELLA A ET AL: "Ultrafast emission of ions during laser ablation of metal for 3D atom probe", APPLIED SURFACE SCIENCE, ELSEVIER, AMSTERDAM, NL, vol. 255, no. 10, 1 mars 2009 (2009-03-01) , pages 5154-5158, XP026001085, ISSN: 0169-4332, DOI: 10.1016/J.APSUSC.2008.08.109 [extrait le 2008-09-12]
- VELLA A ET AL: "Evidence of field evaporation assisted by nonlinear optical rectification induced by ultrafast laser", PHYSICAL REVIEW, B. CONDENSED MATTER, AMERICAN INSTITUTE OF PHYSICS. NEW YORK, US, vol. 73, no. 16, 15 avril 2006 (2006-04-15), pages 165416-1, XP002511470, ISSN: 0163-1829, DOI: 10.1103/PHYSREVB.73.165416
- GAULT B ET AL: "Design of a femtosecond laser assisted tomographic atom probe", REVIEW OF SCIENTIFIC INSTRUMENTS, AIP, MELVILLE, NY, US, vol. 77, no. 4, 10 avril 2006 (2006-04-10) , pages 43705-043705, XP012092987, ISSN: 0034-6748, DOI: 10.1063/1.2194089
- HERINK G ET AL: "Field emission at terahertz frequencies: AC-tunneling and ultrafast carrier dynamics", NEW JOURNAL OF PHYSICS, INSTITUTE OF PHYSICS PUBLISHING, BRISTOL, GB, vol. 16, no. 12, 2 décembre 2014 (2014-12-02), page 123005, XP020274489, ISSN: 1367-2630, DOI: 10.1088/1367-2630/16/12/123005 [extrait le 2014-12-02] cité dans la demande
- MATTE DOMINIQUE ET AL: "Terahertz Field Emission of Femto-Coulomb Electron Bunches", 2018 43RD INTERNATIONAL CONFERENCE ON INFRARED, MILLIMETER, AND TERAHERTZ WAVES (IRMMW-THZ), IEEE, 9 septembre 2018 (2018-09-09), pages 1-3, XP033430362, DOI: 10.1109/IRMMW-THZ.2018.8509839

## Description

L'invention se situe dans le domaine technique général de l'analyse de la composition de matériaux à l'échelle atomique. Elle concerne plus particulièrement les dispositifs d'analyse fonctionnant par évaporation d'un échantillon du matériau au moyen d'une impulsion électrique ou optique. Plus précisément, le domaine de l'invention est celui des sondes atomiques tomographiques.

Dans une sonde atomique tomographique, une tension continue est appliquée sur l'échantillon de matériau à analyser. L'échantillon taillé sous forme de pointe de faible rayon, compris généralement entre 10 et 200 nanomètres est placé dans une enceinte à vide. Le matériau peut être conducteur, isolant ou semi-conducteur. Le champ électrique intense ainsi créé est suffisant pour arracher les atomes de la surface qui sont ionisés et projetés sur un détecteur en position et en temps.

En superposant des impulsions électriques ou lumineuses à la tension continue, les atomes de surface sont évaporés à des instants précis sous forme d'ions. La mesure des temps de vol des ions permet de déterminer leur nature chimique par spectroscopie de masse à temps de vol. Les données recueillies permettent de représenter le volume de l'échantillon détruit à l'échelle de la maille atomique, ainsi que la nature chimique de chaque atome.

La résolution en masse d'une sonde atomique assistée par impulsions électriques dépend de la durée de l'impulsion qui contrôle la durée de l'émission et la dispersion en énergie des ions. La résolution en masse d'une sonde atomique assistée par des impulsions laser femtoseconde dépend de la durée pendant laquelle des ions sont émis consécutivement à l'absorption d'une impulsion lumineuse.

On démontre que cette durée dépend elle-même du mécanisme physique réellement mis en jeu lors de l'évaporation. On distingue ainsi un mécanisme d'évaporation lent dont la durée est supérieure à quelques nanosecondes induit par effet thermique et un mécanisme rapide d'évaporation, toujours induit par effet thermique mais dans lequel, grâce à l'action du champ électrique intense, l'échauffement est plus localisé et les dynamiques thermiques associées sont plus rapides. Ce mécanisme thermique très localisé produit un effet d'arrachement quasi instantané des éléments de l'échantillon. Le premier mécanisme thermique lent est responsable de la limitation de la résolution en masse d'une sonde atomique assisté par impulsion laser.

Les sondes atomiques tomographiques assistées par laser actuellement commercialisées comportent un laser émettant dans le domaine du proche ultraviolet, à une longueur d'onde de 355 nanomètres. Dans le cas des métaux, cette longueur d'onde permet, pour des géométries adaptées de l'échantillon, de confiner l'absorption au bout de l'échantillon. Pour les matériaux semi-conducteurs, ayant un gap inférieur à 3eV, l'absorption de la lumière du laser dans le proche UV est également confinée au bout de l'échantillon. Ce confinement de l'absorption favorise le mécanisme d'évaporation rapide.

Mais, dans le cas des isolants et des semi-conducteurs à grand gap, supérieur à 3eV, l'énergie du laser est faiblement absorbée en bout de pointe et des maxima d'absorption apparaissent loin de cette extrémité, donnant lieu à une évaporation thermique lente et retardée qui dégrade la résolution en masse de l'instrument.

De plus, le fort champ statique appliqué à l'échantillon augmente l'absorption en bout de pointe. Ainsi, l'énergie du laser doit être ajustée selon la valeur du champ électrique appliqué.

En pratique, les conditions d'analyse sont déterminées de façon à favoriser le mécanisme rapide d'évaporation et à minimiser le mécanisme lent. Cependant, ces conditions d'analyse influencent fortement la mesure de composition des matériaux isolants et semi-conducteurs. En particulier, la mesure varie avec la valeur du champ statique appliqué.

Ainsi, les forts champs favorisent l'émission rapide mais peuvent donner lieu à des biais dans les mesures de composition. Par ailleurs, les champs plus faibles peuvent donner des analyses en composition plus fiables mais avec une mauvaise résolution en masse. Enfin, des valeurs de champ ou d'énergie laser trop importantes ont pour conséquence de conduire à la destruction de l'échantillon par effets électrostatique et thermique.

Par conséquent, il est nécessaire de déterminer les conditions de champ et d'éclairement à la fois capables de minimiser l'évaporation lente thermique et de donner des valeurs de composition proches des valeurs nominales. Ces valeurs optimales sont difficiles à déterminer. Elles sont fonction de plusieurs paramètres tels que la composition du matériau analysé ou la géométrie de la pointe de l'échantillon. Or, la composition du matériau analysé n'est, par principe, pas exactement connue. De la même façon, la géométrie exacte de l'échantillon n'est pas parfaitement maîtrisée compte-tenu des faibles dimensions mises en jeu. En outre, l'évaporation de la matière pendant l'analyse change la géométrie de l'échantillon.

Par conséquent, actuellement, les conditions d'analyse optimales relèvent du réglage empirique. Par ailleurs, pour analyser différents échantillons de matériaux, il est généralement nécessaire de réaliser un réglage spécifique pour chaque échantillon analysé, y compris lorsque tous les échantillons sont réalisés dans le même matériau. De plus, la géométrie de l'échantillon variant au cours de l'analyse, les réglages doivent être modifiés en cours d'analyse pour préserver la qualité des spectres de masses et des mesures de composition.

Ainsi, pour pallier ces différents inconvénients, les analyses par sonde atomique sont souvent couplées à des analyses par d'autres techniques telles que la microscopie électronique et la spectroscopie de photoluminescence. La microscopie électronique en transmission permet de déterminer la géométrie et la structure des échantillons en début et en fin d'analyse. La photoluminescence permet de vérifier, dans certains cas, la composition nominale afin de déterminer les espèces majoritaires composant le matériau à partir des spectres d'émission.

La composition des matériaux peut également être mesurée par des techniques alternatives. On citera les méthodes optiques, la microanalyse par spectroscopie dispersive de rayon X ou par spectroscopie de perte d'énergie des électrons ou la diffraction des rayons X. Ces différentes méthodes donnent une indication plus ou moins précise de la composition de l'échantillon. Cette valeur peut être comparée à celle trouvée par la sonde atomique.

Toutefois, les mesures obtenues grâce aux techniques complémentaires ne sont pas toujours comparables à l'information tridimensionnelle obtenue par sonde atomique, notamment sur des nano-objets fortement inhomogènes pour lesquels la distribution des éléments chimiques à l'échelle nanoscopique détermine leur comportement macroscopique.

Ainsi, procéder à la réalisation d'analyses répétitives permettant, par exemple, de contrôler qu'un procédé de réalisation d'un matériau composite ne varie pas, s'avère être une opération difficile et fastidieuse qui conduit parfois à la destruction de certains échantillons. De plus, les tentatives d'analyse de certains matériaux à grand gap comme les fluorures échouent systématiquement et des conditions optimales de champ et d'énergie laser n'ont pu être déterminées dans le cas d'une illumination dans l'ultraviolet.

Enfin, les sondes atomiques s'ouvrent aujourd'hui aux matériaux biologiques et aux liquides qui sont analysés à très basse température pour figer leurs structures. Les premières analyses montrent que l'échauffement induit par le laser ne permet pas une analyse parfaitement correcte de ces échantillons.

Les meilleures solutions existantes permettant de couvrir une large gamme de matériaux s'orientent vers l'exploitation d'impulsions XUV pour aborder les matériaux à grands gaps. On trouvera plus d'informations sur ce type de sonde dans la publication de Miaja-Avila et al. FIO 2018. Intitule "Effects of Deep-Ultraviolet Laser on Laser-assisted Atom Probe Tomography". Cependant, les effets thermiques sont encore plus prépondérants dans ce type de sonde atomique.

La sonde atomique tomographique selon l'invention améliore sensiblement la résolution de la technique d'analyse par sonde atomique tomographique laser à travers l'annulation des effets thermiques inhérents à l'absorption des rayonnements ultraviolet ou infrarouge conventionnellement exploités dans ces instruments. De plus, la solution permet d'élargir les domaines d'application de cette technique notamment pour l'analyse de composés biologiques tout en augmentant le taux de réussite des analyses.

La sonde atomique selon l'invention comporte un système de génération d'impulsions térahertz à large bande spectrale, le matériau échantillonné étant alors une nanopointe polarisée positivement et refroidie à température cryogénique. Cette combinaison inédite comportant l'utilisation d'une source térahertz permet l'évaporation par effet de champ des atomes de la nanopointe.

Plus précisément, l'invention concerne une sonde atomique tomographique comportant une chambre d'analyse fonctionnant à une température ambiante, un dispositif cryogénique, un dispositif électronique et un support antivibratoire, ladite chambre d'analyse destinée à analyser un échantillon de matière se présentant sous la forme d'une nanopointe montée sur le support antivibratoire, ledit dispositif cryogénique destiné à porter ladite nanopointe à une température comprise entre 0 Kelvin et la température ambiante, ledit dispositif électronique destiné à polariser ladite nanopointe à une tension positive ajustable comprise entre 1kV et 15 kV, ladite chambre d'analyse comportant un détecteur d'ions sensible en position et en temps de vol, caractérisé en ce que ladite sonde atomique comporte un générateur d'impulsions térahertz ultrabrèves monocycles à haute intensité crête, la chambre d'analyse comportant des moyens optiques de focalisation des dites impulsions térahertz, la focalisation des impulsions térahertz entraînant l'évaporation des atomes de la nanopointe par effet de champ sans effets thermiques.

Avantageusement, le générateur d'impulsions térahertz produit des impulsions monocycles optiques d'amplitude supérieure à 10kV/cm.

Avantageusement, ledit dispositif cryogénique est destiné à porter la nanopointe à une température inférieure à 200 Kelvins.

Avantageusement, le générateur d'impulsions comporte :
- un laser impulsionnel femtoseconde émettant des impulsions optiques ultrabrèves de très grande puissance dans le domaine spectral du proche infrarouge, les impulsions étant émises à haute cadence,
- un cristal non-linéaire apte à générer, par doublage de fréquence, des radiations optiques de longueur d'onde égale à la moitié de celle des impulsions optiques,
- une optique de focalisation desdites impulsions et des dites radiations optiques, le plasma formé au point de focalisation engendrant les impulsions térahertz,
- un filtre optique assurant l'absorption des impulsions et des radiations optiques et la transmission des ondes térahertz.

Avantageusement, le cristal non-linéaire est du béta borate de baryum, connu sous la dénomination de « BBO » ou du lithium troborate, connu sous la dénomination de « LBO » ou du potassium dideurerium phosphate, connu sous la dénomination « KDP » ou du potassium titanyl phosphate, connu sous la dénomination « KTP».

Avantageusement, le générateur d'impulsions térahertz comporte :
- un laser impulsionnel femtoseconde émettant des impulsions optiques ultrabrèves de très grande puissance dans le domaine spectral du proche infrarouge, les impulsions étant émises à haute cadence,
- une optique de focalisation desdites impulsions optiques,
- un cristal non-linéaire placé au foyer de l'optique de focalisation apte à générer les impulsions térahertz par rectification optique ou par différence de fréquence,
- un filtre optique assurant l'absorption des impulsions optiques et la transmission des ondes térahertz.

Avantageusement, le générateur d'impulsion Terahertz comporte :
- un laser impulsionnel femtoseconde émettant des impulsions optiques ultrabrèves de très grande puissance dans le domaine spectral infrarouge, les impulsions étant émises à haute cadence,
- un dispositif de type antenne basé sur une jonction semi-conductrice soumise à un fort potentiel électrique,
- le déclenchement ultrabref du passage du courant dans la jonction par l'éclairement dudit laser émettant l'impulsion Terahertz.

Avantageusement, le détecteur d'ions a un demi-angle de détection compris entre 1 et 90 degrés.

Avantageusement, le détecteur d'ions est un spectromètre de masse à temps de vol.

Avantageusement, les moyens optiques de focalisation des dites impulsions térahertz sont un miroir sphérique ou parabolique ou une lentille térahertz fonctionnant sur l'axe ou un miroir parabolique fonctionnant hors axe.

Avantageusement, le filtre optique est une plaquette de silicium.

Avantageusement, le laser impulsionnel émet à la longueur d'onde de 400 à 3000 nanomètres des impulsions lumineuses dont l'énergie est comprise entre 0.1 à 4 mJ, la fréquence d'émission étant comprise entre 1 à 200 kHz.

D'autres caractéristiques, détails et avantages de l'invention ressortiront à la lecture de la description faite en référence aux dessins annexés donnés à titre d'exemple et qui représentent, respectivement :
[Fig.1] une illustration d'un premier mode de réalisation d'un générateur térahertz à laser impulsionnel femtoseconde ;
[Fig.2] une illustration d'un second mode de réalisation d'un générateur térahertz à laser impulsionnel femtoseconde ;
[Fig.3] une illustration d'une sonde atomique tomographique selon l'invention.

La sonde atomique tomographique selon l'invention comporte essentiellement une chambre d'analyse destinée à analyser un échantillon de matière et un générateur d'impulsions ultrabrèves térahertz à haute énergie qui va permettre l'analyse de l'échantillon.

Comme il a été dit, il est connu d'utiliser dans ce type de sonde atomique des générateurs d'impulsions ultrabrèves dans le domaine des longueurs d'onde optiques. Pour ce type de sonde, le passage aux ondes térahertz ne saurait se résumer à un simple changement de longueur d'onde ou de fréquence. En effet, à priori, pour l'homme du métier, les ondes térahertz ont des longueurs d'onde trop importantes pour permettre l'évaporation étant donné que l'évaporation en sonde atomique laser est toujours assistée par un effet thermique, que les ondes térahertz ne peuvent pas être focalisées autant que la lumière visible ou ultraviolette et qu'elles sont absorbées moins efficacement.

On notera d'ailleurs que les développements récents de ce type de sonde mettent en oeuvre des impulsions dont les longueurs d'onde sont de plus en plus courtes.

En fait, les ondes térahertz semblent présenter deux inconvénients qui sont les suivants.

Aux fréquences térahertz, l'énergie associée aux photons est extrêmement faible lorsqu'on la compare aux énergies des photons de la lumière visible ou ultraviolette. Cette énergie est environ mille fois plus faible.

Actuellement, l'évaporation par effet de champ assisté par laser utilise des impulsions laser dans le domaine visible ou UV et repose sur un effet thermique induit par l'absorption des photons de lumière. Cette absorption peut avoir lieu seulement si l'énergie du photon est égale ou supérieure à l'énergie de la bande interdite du matériau. L'énergie de la bande interdite peut varier entre une fraction d'eV à plusieurs eV. Par exemple, elle est de 8 eV le cas de l'oxyde de magnésium. Les photons UV ayant des énergies supérieures ou comparables à l'énergie de la bande interdite de nombreux matériaux, ils sont alors absorbés par le matériau qui va chauffer et induire une évaporation des atomes de surface par effet thermique. Or, les photons THz ayant une énergie 1000 fois plus faible ne vont pas être absorbés par le matériau, qui donc ne peut pas, a priori, s'évaporer.

Par ailleurs, le champ électrique associé aux impulsions THz générées par les dispositifs les plus performants développés dans les laboratoires de recherche est très faible comparé aux valeurs de champ électrique nécessaire pour induire une évaporation par effet de champ. Cela est dû à la fois à la faible énergie des impulsions térahertz que l'on sait générer et au fait que, en raison de leur grande longueur d'onde, ces impulsions ne peuvent pas être focalisées autant que la lumière visible ou ultraviolette. Ainsi, le champ THz généré est inférieur à 10³ kV/cm alors que le champ nécessaire à l'évaporation est de 3.10⁵ kV/cm, soit trois cents fois supérieur.

Aussi, l'exploitation de ces impulsions THz s'est jusqu'à présent limitée à l'émission d'électrons à partir de nanopointes polarisées négativement, nécessitant des champs électriques plus faibles qui sont compatibles avec les intensités disponibles des sources d'impulsions THz actuelles. C'est la solution abordée dans le document de Herink et al. NJP 16 (2014) intitule "Field émission at terahertz frequencies: AC-tunneling and ultrafast carrier dynamics".

En fait, ces raisonnements ignorent deux effets physiques qui vont permettre d'accroître de façon très sensible les effets des ondes térahertz.

Le premier effet est l'effet d'antenne qui va donner lieu à une exaltation du champ THz de plusieurs ordres de grandeurs, en particulier dans le cas des métaux. Cette exaltation va rendre le champ THz comparable au champ électrique statique nécessaire à l'évaporation par effet de champ. Ainsi, il aura une amplitude suffisamment intense pour donner lieu à l'évaporation des atomes de surface et une période d'oscillation du champ, aux fréquences THz suffisamment grande pour permettre aux atomes de franchir la barrière d'énergie afin de s'ioniser. Dans ce cas, un éclairement des échantillons par des impulsions THz intenses, permet l'évaporation par effet de champ optique. L'impulsion THz est alors équivalente à une impulsion électrique très rapide.

Le second effet est l'effet résonnant. Les fréquences THz correspondent aux fréquences d'oscillation des atomes à la surface de la nanopointe, une absorption résonante est alors possible. Cette absorption est très sélective. Elle ne peut avoir lieu que pour les atomes de la surface de la nanopointe fortement polarisée. Ainsi, elle n'engendre pas d'échauffement mais une évaporation contrôlée des atomes de surface. Dans le cas d'échantillons de semi-conducteurs ou d'isolants, les études autour du comportement sous champ intense des molécules de ces échantillons permettent de mettre en évidence un changement des fréquences vibrationnelles. Ces fréquences décroissent et sont de l'ordre de quelques THz.

Il est donc possible d'exciter de façon résonante et sélective ces molécules par un rayonnement THz de faible amplitude. Dans ce cas, la faible amplitude des impulsions THz rend les effets thermiques totalement négligeables.

La sonde atomique selon l'invention repose sur ces deux principes qui sont la génération d'impulsions THz intenses et l'utilisation d'échantillons sous forme de nanopointes polarisées positivement et refroidies. Les effets physiques mis en jeu sont les mécanismes d'exaltation du champ THz par effet d'antenne ou d'absorption résonante permettant d'induire une émission ionique contrôlée à la surface du matériau.

Il existe différentes solutions techniques pour réaliser un dispositif de génération d'ondes térahertz. On trouvera des informations techniques sur cette technique dans les publications suivantes :
- Génération of single-cycle THz transients with high electric-field amplitudes de T. Bartel et al / October 15, 2005, Vol. 30, N° 20 / Optics Letters ;
- Terahertz wave air Photonics: Terahertz Wave Génération and Detection with Laser-induced Gas Plasma de Jianming Dai et al /2010 / IEEE Journal of selected topics in Quantum Electronics ;
- Field émission at terahertz frequencies: AC-tunneling and ultrafast carrier dynamics de G. Herink et al / New journal of Physics 16 (2014) 123005.

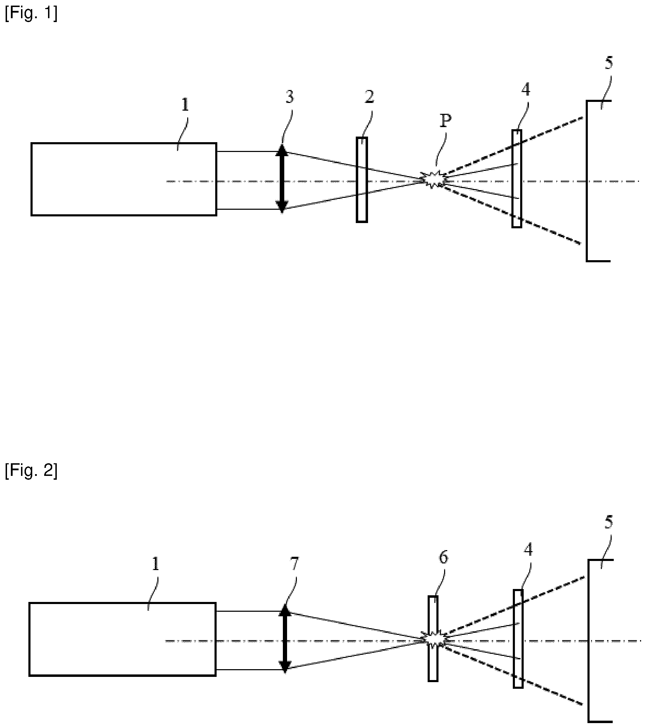

A titre de premier exemple de réalisation, un premier générateur térahertz est représenté sur la figure 1. Sur cette figure comme sur les deux suivantes, les ondes lumineuses sont représentées par des traits continus et les impulsions térahetz par des traits en pointillés.

Ce générateur térahertz comporte une source laser femtoseconde 1 émettant à haute cadence des impulsions ultrabrèves de très grande puissance dans le proche infrarouge. Chaque impulsion se propage à l'intérieur d'un cristal non linéaire 2 afin de générer une radiation de fréquence double. Le cristal non linéaire est, par exemple, du béta borate de baryum, connu sous la dénomination de « BBO ». La longueur d'onde de la radiation est donc située dans le proche ultraviolet. On pourrait également utiliser du lithium troborate, connu sous la dénomination de « LBO » ou du potassium dideurerium phosphate, connu sous la dénomination « KDP » ou du potassium titanyl phosphate, connu sous la dénomination « KTP».

Cette radiation ainsi que l'impulsion initiale sont focalisées à l'aide d'une lentille optique 3 dans l'air, formant ainsi un plasma P. Celui-ci irradie une onde térahertz. L'impulsion d'origine et son harmonique sont filtrées au moyen d'une plaquette en silicium 4 à haute résistance qui transmet le rayonnement térahertz. On obtient ainsi une source de rayonnement térahertz. Cette onde térahertz est ensuite transportée, collimatée et focalisée par un dispositif optique 5 qui n'est pas détaillé sur la figure 1.

A titre de second exemple, un second dispositif est représenté sur la figure 2. Il comporte également une source laser femtoseconde 1 émettant à haute cadence des impulsions ultrabrèves de très grande puissance dans le proche infrarouge. Chaque impulsion est focalisée à l'intérieur d'un cristal non linéaire 6 au moyen d'une optique 7. Le cristal non linéaire est, par exemple, du tellurure de zinc de formule ZnTe, du niobate de lithium de formule LiNbO3 ; Ce cristal peut également être de type « DAST » dont la formule chimique est 4-N, N-dimethylamino-4-N-methyl-stilbazolium tosylate, de type « DSTMS » dont la formule chimique est 4-N,N-dimethylamino-4'-N'-methylstilbazolium 2,4,6-trimethylbenzenesulfo-nate ou de type « OH1 » dont la formule chimique est 3-3-(4-Hydroxystyryl)-5,5-dimethylcyclohex-2-enylidene)malononitrile.

Celui-ci génère une onde térahertz par rectification optique ou par différence de fréquence. La rectification optique est l'effet réciproque de l'effet Pockels. L'impulsion d'origine est filtrée, de la même façon, au moyen d'une plaquette en silicium 4 à haute résistance qui transmet le rayonnement térahertz. On obtient ainsi une source de rayonnement térahertz.

A titre de troisième exemple non représenté, le générateur d'impulsion Terahertz comporte :
- un laser impulsionnel femtoseconde émettant des impulsions optiques ultrabrèves de très grande puissance dans le domaine spectral infrarouge, les impulsions étant émises à haute cadence,
- un dispositif de type antenne basé sur une jonction semi-conductrice soumise à un fort potentiel électrique, le déclenchement ultrabref du passage du courant dans la jonction par l'éclairement dudit laser émettant l'impulsion Terahertz.

Dans ces différentes configurations, le laser impulsionnel émet à une longueur d'onde centrale comprise entre 400 et 3000 nanomètres des impulsions lumineuses dont l'énergie est comprise entre 0.1 à 4 mJ, la fréquence d'émission étant comprise entre 1 à 200 kHz.

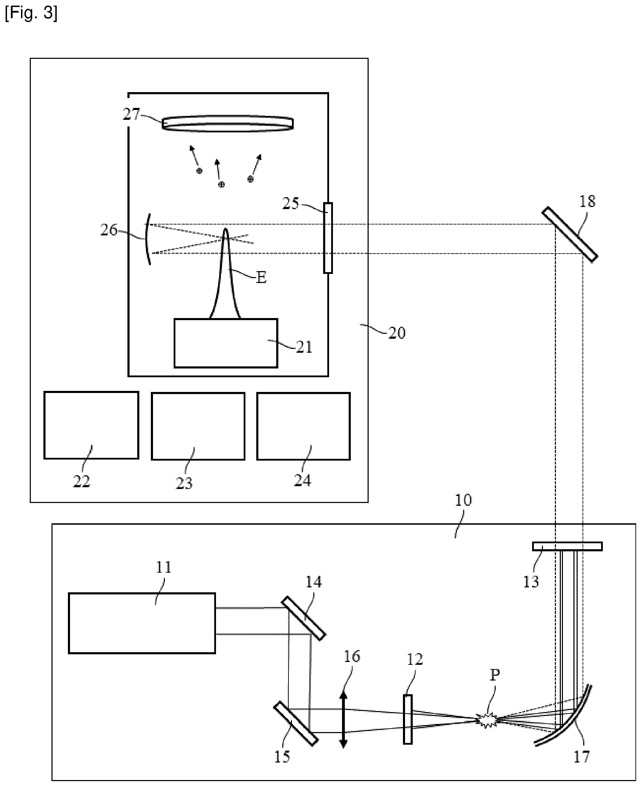

A titre d'exemple de réalisation, une sonde atomique tomographique selon l'invention est représentée sur la figure 3. Elle comporte deux ensembles principaux qui sont :
- le générateur d'impulsions terahertz 10 ;
- la chambre d'analyse 20.

Sur cette figure 3, le générateur térahertz est du même type que celui représenté sur la figure 1. Le générateur térahertz représenté sur la figure 2 pourrait également convenir.

Le générateur représenté sur la figure 3 comporte essentiellement une source laser femtoseconde 11, un cristal non linéaire doubleur de fréquence 12, un filtre 13 et différentes optiques 14, 15, 16, 17 et 18. Les caractéristiques de ces différents éléments sont les suivantes :
- Source laser femtoseconde 11
   . Longueur d'onde des impulsions : 800 nanomètres
   . Durée des impulsions : quelques dizaines de femtosecondes
   . Cadence des impulsions : 1 kHertz
   . Energie des impulsions : 2mJ à 4 mJ
- Cristal non linéaire 12
   . Substrat en BBO (béta borate de baryum)
   . Longueur d'onde de l'harmonique : 400 nanomètres
- Filtre 13
   . Substrat en silicium

Les éléments optiques 14 et 15 sont de simples miroirs plans de renvoi. La première lentille 16 focalise les impulsions lumineuses et assure la formation du plasma P. Le premier miroir 16 est un miroir parabolique hors d'axe qui assure la collimation des ondes térahertz. Le second miroir 18 est un miroir plan comportant un traitement d'oxyde Indium-Etain dit « ITO » qui assure la réflexion des ondes térahertz.

La chambre d'analyse 20 est une chambre à vide. Elle est destinée à analyser des échantillons E de différentes natures et de différentes compositions. Ces échantillons peuvent être des matériaux métalliques, semi-conducteurs, des oxydes ou des matériaux biologiques ou pharmaceutiques. Ces matériaux peuvent être à grand gap électronique.

Ces échantillons E ont une forme de nanopointe. La chambre d'analyse comporte un support d'échantillon 21 monté sur un dispositif antivibratoire, un dispositif pièzo-électrique 22 permettant de positionner finement l'échantillon, des moyens électroniques 23 permettant de porter la nanopointe à une tension supérieure à 10 kVolts. La chambre comporte un compresseur cryogénique 24 permettant de refroidir la nanopointe à une température comprise entre 0 Kelvin et 80 Kelvins. Il est possible de travailler à des températures plus élevées, typiquement de l'ordre de 200 Kelvins, voire à la température ambiante.

La chambre d'analyse comporte une fenêtre 25 en diamant qui permet la transmission des ondes térahertz et un miroir sphérique 26 qui permet la focalisation des ondes térahertz sur la nanopointe de l'échantillon. Ce miroir sphérique travaille sur son axe. On pourrait également utiliser un miroir parabolique ou une lentille térahertz fonctionnant sur l'axe ou encore un miroir parabolique fonctionnant hors axe.

La chambre d'analyse comporte un détecteur 27 sensible en position et en temps de vol avec un grand angle de vue de +/- 90° permettant de calculer par rétroprojection la position d'origine dans l'échantillon des ions émis avec une résolution inférieure au nanomètre. Les ions sont représentés par des croix cerclées sur la figure 3. Le détecteur comporte également des moyens d'identifier chimiquement les ions émis par la spectrométrie de masse à temps de vol.

La sonde atomique comporte des moyens de caractérisation des ondes térahertz par des méthodes électro-optiques. On peut utiliser, à cet effet, un cristal électro-optique comme le phosphure de gallium (GaP) ou le tellurure de zinc (ZnTe). Ces méthodes sont connues de l'homme du métier.

La sonde atomique comporte enfin différents moyens électroniques d'alimentation électrique, de contrôle, de gestion et de traitement assurant l'alimentation des différents dispositifs, leur synchronisation, la mémorisation des mesures ainsi que leur traitement. Ces différents moyens ne sont pas représentés sur la figure 3.

En particulier, les moyens de traitement comportent des algorithmes de reconstruction permettant de réaliser une tomographie chimique de l'échantillon analysé.

La sonde atomique tomographique assistée par impulsion THz selon l'invention a comme avantages principaux :
- d'assurer l'analyse de tout type de matériau en conditions optimales, indépendamment de la géométrie et de la composition du matériau ;
- d'augmenter la fiabilité des mesures de composition des matériaux métalliques, semi-conducteurs et oxydes ;
- d'augmenter le taux de réussite des analyses sur ces matériaux ;
- d'analyser des matériaux à grand gap et des matériaux biologiques et pharmaceutiques.

## Revendications

1. Sonde atomique tomographique comportant une chambre d'analyse (20) fonctionnant à une température ambiante, un dispositif cryogénique (24), un dispositif électronique (23), et un support antivibratoire (21), ladite chambre d'analyse destinée à analyser un échantillon (E) de matière se présentant sous la forme d'une nanopointe montée sur le support antivibratoire (21), ledit dispositif cryogénique (24) destiné à porter ladite nanopointe à une température comprise entre 0 Kelvin et la température ambiante, ledit dispositif électronique (23) destiné à polariser ladite nanopointe à une tension positive ajustable comprise entre 1kV et 15 kV, ladite chambre d'analyse comportant un détecteur (27) d'ions sensible en position et en temps de vol, **caractérisé en ce que** ladite sonde atomique comporte un générateur (10) d'impulsions térahertz ultrabrèves monocycles à haute intensité crête, la chambre d'analyse comportant des moyens optiques (26) de focalisation des dites impulsions térahertz, la focalisation des impulsions térahertz entraînant l'évaporation des atomes de la nanopointe par effet de champ sans effets thermiques.

2. Sonde atomique tomographique selon la revendication 1, **caractérisé en ce que**, le générateur d'impulsions térahertz produit des impulsions monocycles optiques d'amplitude supérieure à 10kV/cm.

3. Sonde atomique tomographique selon l'une des revendications précédentes, **caractérisé en ce que** ledit dispositif cryogénique (24) est destiné à porter la nanopointe à une température inférieure à 200 Kelvins.

4. Sonde atomique tomographique selon l'une des revendications précédentes, **caractérisé en ce que** le générateur d'impulsions térahertz comporte :
- un laser (1, 11) impulsionnel femtoseconde émettant des impulsions optiques ultrabrèves de très grande puissance dans le domaine spectral du proche infrarouge, les impulsions étant émises à haute cadence,
- un cristal non-linéaire (2, 12) apte à générer, par doublage de fréquence, des radiations optiques de longueur d'onde égale à la moitié de celle des impulsions optiques,
- une optique de focalisation (3, 16) desdites impulsions et des dites radiations optiques, le plasma formé au point de focalisation engendrant les impulsions térahertz,
- un filtre optique (4, 13) assurant l'absorption des impulsions et des radiations optiques et la transmission des ondes téraherz.

5. Sonde atomique tomographique selon la revendication 4, **caractérisé en ce que** le cristal nonlinéaire est du béta borate de baryum, connu sous la dénomination de « BBO » ou du lithium troborate, connu sous la dénomination de « LBO » ou du potassium dideurerium phosphate, connu sous la dénomination « KDP » ou du potassium titanyl phosphate, connu sous la dénomination « KTP».

6. Sonde atomique tomographique selon l'une des revendications 1 à 3, **caractérisé en ce que** le générateur d'impulsions térahertz comporte :
- un laser (1) impulsionnel femtoseconde émettant des impulsions optiques ultrabrèves de très grande puissance dans le domaine spectral du proche infrarouge, les impulsions étant émises à haute cadence,
- une optique (7) de focalisation desdites impulsions optiques,
un cristal non-linéaire (6) placé au foyer de l'optique de focalisation apte à générer les impulsions térahetz par rectification optique ou par différence de fréquence,
- un filtre optique (4) assurant l'absorption des impulsions optiques et la transmission des ondes téraherz.

7. Sonde atomique tomographique selon l'une des revendications 1 à 3, **caractérisé en ce que** le générateur d'impulsions térahertz comporte :
- un laser impulsionnel femtoseconde émettant des impulsions optiques ultrabrèves de très grande puissance dans le domaine spectral infrarouge, les impulsions étant émises à haute cadence,
- un dispositif de type antenne basé sur une jonction semi-conductrice soumise à un fort potentiel électrique, le déclenchement ultrabref du passage du courant dans la jonction par l'éclairement dudit laser émettant l'impulsion Terahertz.

8. Sonde atomique tomographique selon l'une des revendications précédentes, **caractérisé en ce que** le détecteur d'ions à un demi-angle de détection compris entre 1 et 90 degrés.

9. Sonde atomique tomographique selon l'une des revendications précédentes, **caractérisé en ce que** le détecteur d'ions est un spectromètre de masse à temps de vol.

10. Sonde atomique tomographique selon l'une des revendications précédentes, **caractérisé en ce que** les moyens optiques de focalisation des dites impulsions térahertz sont un miroir sphérique ou parabolique ou une lentille térahertz fonctionnant sur l'axe ou un miroir parabolique fonctionnant hors d'axe.

11. Sonde atomique tomographique selon l'une des revendications 4 à 10, **caractérisé en ce que** le filtre optique est une plaquette de silicium.

12. Sonde atomique tomographique selon l'une des revendications 4 à 11, **caractérisé en ce que** le laser impulsionnel émet à une longueur d'onde comprise entre 400 et 3000 nanomètres des impulsions lumineuses dont l'énergie est comprise entre 0.1 à 4 mJ, la fréquence d'émission étant comprise entre 1 à 200 kHz.

## Patentansprüche

1. Tomographische Atomsonde, aufweisend eine Analysekammer (20), die bei einer Umgebungstemperatur arbeitet, eine kryogene Vorrichtung (24), eine elektronische Vorrichtung (23) und eine schwingungsdämpfende Halterung (21), wobei die Analysekammer dazu bestimmt ist, eine Materialprobe (E) zu analysieren, die in Form einer auf der schwingungsdämpfenden Halterung (21) montierten Nanospitze vorliegt, wobei die kryogene Vorrichtung (24) dazu bestimmt ist, die Nanospitze auf eine Temperatur zwischen 0 Kelvin und Raumtemperatur zu bringen, wobei die elektronische Vorrichtung (23) dazu bestimmt ist, die Nanospitze auf eine einstellbare positive Spannung zwischen 1 kV und 15 kV zu polarisieren, wobei die Analysekammer einen positions- und flugzeitempfindlichen Ionendetektor (27) aufweist, **dadurch gekennzeichnet, dass** die Atomsonde einen Generator (10) für ultrakurze monozyklische Terahertz-Impulse mit hoher Spitzenintensität aufweist, wobei die Analysekammer optische Mittel (26) zur Fokussierung der Terahertz-Impulse aufweist, wobei die Fokussierung der Terahertz-Impulse die Verdampfung der Atome der Nanospitze durch Feldeffekt ohne thermische Effekte zur Folge hat.

2. Tomographische Atomsonde nach Anspruch 1, **dadurch gekennzeichnet, dass** der Terahertz-Impulsgenerator monozyklische optische Impulse mit einer Amplitude von mehr als 10 kV/cm erzeugt.

3. Tomographische Atomsonde nach einem der vorhergehenden Ansprüche, **dadurch gekennzeichnet, dass** die kryogene Vorrichtung (24) dazu bestimmt ist, die Nanospitze auf eine Temperatur unter 200 Kelvin zu bringen.

4. Tomographische Atomsonde nach einem der vorhergehenden Ansprüche, **dadurch gekennzeichnet, dass** der Terahertz-Impulsgenerator Folgendes aufweist:
- einen Femtosekunden-Impulslaser (1, 11), der ultrakurze optische Impulse mit sehr hoher Leistung im Spektralbereich des nahen Infrarot emittiert, wobei die Impulse mit hoher Taktrate ausgesendet werden,
- einen nichtlinearen Kristall (2, 12), der in der Lage ist, durch Frequenzverdopplung optische Strahlungen mit einer Wellenlänge zu erzeugen, die gleich der Hälfte derjenigen der optischen Impulse ist,
- eine Fokussierungsoptik (3, 16) für die Impulse und die optischen Strahlungen, wobei das am Fokussierungspunkt gebildete Plasma die Terahertz-Impulse erzeugt,
- einen optischen Filter (4, 13), der die Absorption der Impulse und der optischen Strahlungen und die Übertragung der Terahertzwellen gewährleistet.

5. Tomographische Atomsonde nach Anspruch 4, **dadurch gekennzeichnet, dass** der nichtlineare Kristall Bariumbetaborat, bekannt als "BBO", oder Lithiumtriborat, bekannt als "LBO", oder Kaliumdideuteriumphosphat, bekannt als "KDP", oder Kaliumtitanylphosphat, bekannt als "KTP", ist.

6. Tomographische Atomsonde nach einem der Ansprüche 1 bis 3, **dadurch gekennzeichnet, dass** der Terahertz-Impulsgenerator Folgendes aufweist:
- einen Femtosekunden-Impulslaser (1), der ultrakurze optische Impulse mit sehr hoher Leistung im Spektralbereich des nahen Infrarot emittiert, wobei die Impulse mit hoher Taktrate ausgesendet werden,
- eine Fokussierungsoptik (7) für die optischen Impulse,
einen nichtlinearen Kristall (6), der im Brennpunkt der Fokussierungsoptik platziert ist und in der Lage ist, die Terahertz-Impulse durch optische Berichtigung oder durch Frequenzdifferenz zu erzeugen,
- einen optischen Filter (4), der die Absorption der optischen Impulse und die Übertragung der Terahertzwellen gewährleistet.

7. Tomographische Atomsonde nach einem der Ansprüche 1 bis 3, **dadurch gekennzeichnet, dass** der Terahertz-Impulsgenerator Folgendes aufweist:
- einen Femtosekunden-Impulslaser, der ultrakurze optische Impulse mit sehr hoher Leistung im Spektralbereich Infrarot emittiert, wobei die Impulse mit hoher Taktrate ausgesendet werden,
- eine Vorrichtung vom Typ Antenne, die auf einem Halbleiterübergang basiert, der einem hohen elektrischen Potenzial ausgesetzt ist,
- die ultrakurze Auslösung des Stromflusses in dem Übergang durch die Beleuchtung des Lasers, der den Terahertz-Impuls aussendet.

8. Tomographische Atomsonde nach einem der vorhergehenden Ansprüche, **dadurch gekennzeichnet, dass** der Ionendetektor einen halben Detektionswinkel zwischen 1 und 90 Grad aufweist.

9. Tomographische Atomsonde nach einem der vorhergehenden Ansprüche, **dadurch gekennzeichnet, dass** der Ionendetektor ein Flugzeitmassenspektrometer ist.

10. Tomographische Atomsonde nach einem der vorhergehenden Ansprüche, **dadurch gekennzeichnet, dass** die optischen Mittel zur Fokussierung der Terahertz-Impulse ein sphärischer oder parabolischer Spiegel oder eine auf der Achse arbeitende Terahertz-Linse oder ein außerhalb der Achse arbeitender parabolischer Spiegel sind.

11. Tomographische Atomsonde nach einem der Ansprüche 4 bis 10, **dadurch gekennzeichnet, dass** der optische Filter ein Siliziumwafer ist.

12. Tomographische Atomsonde nach einem der Ansprüche 4 bis 11, **dadurch gekennzeichnet, dass** der Impulslaser bei einer Wellenlänge zwischen 400 und 3000 Nanometer Lichtimpulse aussendet, deren Energie zwischen 0,1 und 4 mJ liegt, wobei die Sendefrequenz zwischen 1 und 200 kHz liegt.

## Claims

1. A tomographic atom probe having an analysis chamber (20) operating at ambient temperature, a cryogenic device (24), an electronic device (23), and an anti-vibration support (21), said analysis chamber being intended to analyse a sample (E) of material in the form of a nanotip mounted on the anti-vibration support (21), said cryogenic device (24) being intended to support said nanotip at a temperature of between 0 kelvin and ambient temperature, said electronic device (23) being intended to polarise said nanotip at an adjustable positive voltage between 1 kV and 15 kV, said analysis chamber having a position-sensitive and time of flight-sensitive ion detector (27), **characterised in that** said atom probe has a generator (10) for high-peak-intensity single-cycle ultrashort terahertz pulses, the analysis chamber having optical means (26) for focusing said terahertz pulses, the focusing of the terahertz pulses causing the atoms of the nanotip to evaporate through a field effect without thermal effects.

2. The tomographic atom probe according to claim 1, **characterised in that** the terahertz pulse generator produces optical single-cycle pulses with an amplitude greater than 10 kV/cm.

3. The tomographic atom probe according to one of the preceding claims, **characterised in that** said cryogenic device (24) is intended to bring the nanotip to a temperature lower than 200 kelvins.

4. The tomographic atom probe according to one of the preceding claims, **characterised in that** the terahertz pulse generator has:
- a femtosecond pulsed laser (1, 11) emitting very high-power ultrashort optical pulses in the near-infrared spectral range, the pulses being emitted at a high rate,
- a non-linear crystal (2, 12) able to generate, through frequency doubling, optical radiation with a wavelength equal to half that of the optical pulses,
- a focusing optics (3, 16) for said pulses and said optical radiation, the plasma formed at the focal point generating the terahertz pulses,
- an optical filter (4, 13) ensuring the absorption of the pulses and optical radiation and the transmission of the terahertz waves.

5. The tomographic atom probe according to claim 4, **characterised in that** the non-linear crystal is beta barium borate, known by the name "BBO", or lithium triborate, known by the name "LBO", or potassium dideuterium phosphate, known by the name "KDP", or potassium titanyl phosphate, known by the name "KTP".

6. The tomographic atom probe according to one of claims 1 to 3, **characterised in that** the terahertz pulse generator has:
- a femtosecond pulsed laser (1) emitting very high-power ultrashort optical pulses in the near-infrared spectral range, the pulses being emitted at a high rate,
- a focusing optics (7) for said optical pulses,
a non-linear crystal (6) placed at the focal point of the focusing optics, able to generate the terahertz pulses through optical rectification or through frequency difference,
- an optical filter (4) for absorbing the optical pulses and transmitting the terahertz waves.

7. The tomographic atom probe according to one of claims 1 to 3, **characterised in that** the terahertz pulse generator has:
- a femtosecond pulsed laser emitting very high-power ultrashort optical pulses in the infrared spectral range, the pulses being emitted at a high rate,
- an antenna-type device based on a semiconductor junction subjected to a high electrical potential,
- the ultrashort triggering of the flow of current in the junction through the illumination of said laser emitting the terahertz pulse.

8. The tomographic atom probe according to one of the preceding claims, **characterised in that** the ion detector has a detection half-angle of between 1 and 90 degrees.

9. The tomographic atom probe according to one of the preceding claims, **characterised in that** the ion detector is a time-of-flight mass spectrometer.

10. The tomographic atom probe according to one of the preceding claims, **characterised in that** the optical means for focusing said terahertz pulses are a spherical or parabolic mirror or a terahertz lens operating on-axis or a parabolic mirror operating off-axis.

11. The tomographic atom probe according to one of claims 4 to 10, **characterised in that** the optical filter is a silicon wafer.

12. The tomographic atom probe according to one of claims 4 to 11, **characterised in that** the pulsed laser emits, at a wavelength of between 400 and 3 000 nanometres, light pulses whose energy is between 0.1 and 4 mJ, the emission frequency being between 1 and 200 kHz.
